# EUROPÄISCHE PATENTSCHRIFT

(11) **EP 2 932 810 B1**
(45) Veröffentlichungstag und Bekanntmachung des Hinweises auf die Patenterteilung: **06.09.2017**
(21) Anmeldenummer: 13742616.9
(22) Anmeldetag: 25.07.2013
(51) Int. Cl.: H05K 5/06, F16J 15/06

(54) **GEHÄUSEABDICHTUNG ZWEIER ANEINANDERLIEGENDER GEHÄUSETEILE**
HOUSING SEAL OF TWO HOUSING PARTS LYING AGAINST EACH OTHER
DISPOSITIF D'ÉTANCHÉITÉ ENTRE DEUX PARTIES DE BOÎTIER ADJACENTES

(30) Priorität: 17.12.2012 DE 102012223354
(43) Veröffentlichungstag der Anmeldung: 21.10.2015
(73) Patentinhaber: Robert Bosch GmbH, 70442 Stuttgart (DE)
(72) Erfinder: KNAB, Norbert, 77767 Appenweier (DE); RIEHL, Guenther, 77815 Buehl (DE); THIERY, Jerome, F-67100 Strasbourg (FR); MONZIE, Benoit, F-67850 Herrlisheim (FR); WOLF, Joerg, 76139 Karlsruhe (DE); HEIER, Christoph, 76473 Iffezheim (DE); DECKER, Werner, 77815 Buehl (DE); EPPEL, Klaus, 77886 Lauf (DE); MUSCHELKNAUTZ, Claudius, 77815 Buehl (DE); SCHMIDT, Roland, 77815 Buehl (DE); KLAPPENBACH, Christoph, 77833 Ottersweier-Unzhurst (DE); LOJOWSKI, Thomas, 77833 Ottersweier (DE)
(86) Internationale Anmeldenummer: PCT/EP2013/065712
(87) Internationale Veröffentlichungsnummer: WO 2014/095096

(56) Entgegenhaltungen:
- WO-A1-93/10585
- DE-A1-102010 042 137
- JP-A- 2006 012 877

## Beschreibung

### Stand der Technik

Die vorliegende Erfindung betrifft eine Gehäuseabdichtung zweier aneinanderliegender Gehäuseteile, eines ersten Gehäuseteils mit einer ersten Dichtfläche und eines zweiten Gehäuseteils mit einer zweiten Dichtfläche, mit einer Dichtung, eingebracht in einer Nut in der ersten Dichtfläche des ersten Gehäuseteils, wobei die Nut von der zweiten Dichtfläche des zweiten Gehäuseteils überdeckt ist.

Es ist erforderlich bei einer Vielzahl von technischen Anwendungen, elektronische oder mechanische oder sonstige Komponenten vor Umgebungseinflüssen zu schützen. Hierzu werden in der Regel mehrteilige Gehäuse, mit Deckeln und dergleichen, eingesetzt, die unter Verwendung von Dichtungen verschlossen werden. Zumindest bei einzelnen Gehäuseteilen ist es üblich, diese aus metallischen Werkstoffen herzustellen, da diese über entsprechend mechanische, elektrische oder sonstige Eigenschaften verfügen. Metalle allgemein werden jedoch durch Umgebungseinflüsse, wie Feuchte, Wasser, Salz und dergleichen korrosiv angegriffen. Korrosive Bedingungen, wie sie beispielsweise im winterlichen Straßenverkehr herrschen, führen daher zu einem Angriff auf die Metalle, welcher von einer metallenen Oberfläche eines Bauteils ausgeht. Da Dichtungen in der Regel in sehr engen Fügespalten zwischen Gehäuseteilen, insbesondere unter Deckeln, eingesetzt werden, tritt im Bereich der Dichtungen eine verstärkte Spaltkorrosion auf. Diese Spaltkorrosion kann die Dichtung entlang der Metalloberflächen unterwandern, so dass es zu einer Undichtigkeit und damit zu einem Eintreten von korrosiven Medien aus der Umgebung in das Innere des Gehäuses kommen kann.

Aus WO 93/10585 A1 beschreibt einen Kabelverbinder mit einem Gehäuse, wobei zur Abdichtung ein Dichtelement zwischen zwei Dichtflächen eingeklemmt wird.

Aus DE 10 2010 042137 A1 ist eine Abdichtung zwischen Gehäuseteilen, insbesondere zwischen einem Gehäuse und einem Gehäusedeckel bekannt, die miteinander verspannbar sind. Die Verformung des zwischen den Gehäuseteilen angeordneten Dichtkörpers wird durch mindestens einen festen Anschlag des Gehäuseteils an das andere Gehäuseteil begrenzt. Der mindestens eine Anschlag ist bezogen auf den Dichtungskörper gehäuseinnenseitig angeordnet, wodurch die Spaltkorrosion im Dichtungsbereich deutlich vermindert wird.

Aus JP 2006 012877 A ist eine Gehäuseabdichtung zweier, aneinanderliegender Gehäuseteile bekannt, wobei ein erstes Gehäuseteil mit einer ersten Dichtfläche einem zweiten Gehäuseteil mit einer zweiten Dichtfläche zugeordnet ist, wobei eine Dichtung vorgesehen ist, wobei die Dichtung in einer Nut der ersten Dichtfläche des ersten Gehäuseteils eingebracht ist, wobei die Nut von der zweiten Dichtfläche des zweiten Gehäuseteils überdeckt ist. Die Nut weist eine Öffnung zwischen den Dichtflächen auf, die zur Belüftung der Nut mit der eingebrachten Dichtung dient. Die Öffnung ist in zwei Abschnitte unterteilt, wobei ein erster Abschnitt in einem Winkel geneigt zur Nut angeordnet ist, wobei der erste Abschnitt in einen zweiten Abschnitt übergeht, der in radialer Richtung zur Nut angeordnet ist.

### Offenbarung der Erfindung

Die erfindungsgemäße Gehäuseabdichtung mit den Merkmalen des Anspruchs 1 hat demgegenüber den Vorteil, dass eine korrosionsbedingte Unterwanderung der Dichtung insbesondere an Metallgehäusen und ein Eindringen von Flüssigkeit und korrosiven Medien (Feuchtigkeit, Salze, etct.) in das Innere des Gehäuses in einfacher Art und Weise zuverlässig verhindert werden kann.

Zum weiter verbesserten Korrosionsschutz ist die Öffnung als radialer Spalt ausgebildet.

Zum effektiven Korrosionsschutz hat sich dabei herausgestellt, die Öffnung mit einer Öffnungsbreite in einem Bereich von 0,5 bis 1 mm auszuführen.

Weitere Vorteile und vorteilhafte Ausgestaltungen der Erfindung ergeben sich aus den Unteransprüchen und der Beschreibung.

Eine einfache Ausgestaltung zur erfindungsgemäßen Belüftung der Dichtung ist gegeben, wenn die zweite Dichtfläche des zweiten Gehäuseteils die Nut nur minimal überragt und die Öffnung durch eine abgebogene bzw. abgerundete oder eckgie Gestaltung eines Dichtflächenendes der zweiten Dichtfläche gebildet ist.

In einfacher Art und Weise kann die Öffnung zu einer im zweiten Gehäuseteil vorgesehenen Aussparung am zweiten Gehäuseteil führen.

Zum weiter verbesserten Korrosionsschutz bei einer vorgesehenen Schraubverbindung beider Gehäuseteile ist die Aussparung im Bereich von Schraubaugen der Schraubverbindung in Form einer Belüftungsnut gestaltet.

Eine effiziente Gehäuseabdichtung liegt vor, wenn die Dichtung als O-Ringdichtung mit rundem Querschnitt ausgeführt ist.

Eine effiziente Gehäuseabdichtung liegt vor, wenn die Dichtung einen eckigen, insbesondere quadratischen Querschnitt aufweist.

Eine effiziente Gehäuseabdichtung liegt vor, wenn zumindest ein Gehäuseteil zumindest teilweise aus Metall besteht.

Bei einer Ausgestaltung der Gehäuseabdichtung kann ein Gehäuseteil als Deckel ausgebildet sein.

### Zeichnung

Ausführungsbeispiele der Erfindung sind in der nachfolgenden Beschreibung näher erläutert und anhand der Zeichnung weiter verdeutlicht.

Es zeigen:
Fig. 1 eine erste Ausführungsform einer Gehäuseabdichtung in vereinfachter Schnittdarstellung, ausgebildet nach dem Stand der Technik,
Fig. 2 eine zweite Ausführungsform der Gehäuseabdichtung in vereinfachter Schnittdarstellung, ausgebildet nach dem Stand der Technik,
Fig. 3 eine erste erfindungsgemäße Ausführungsform der Gehäuseabdichtung in vereinfachter Schnittdarstellung.
Fig. 4 eine zweite erfindungsgemäße Ausführungsform der Gehäuseabdichtung in vereinfachter Schnittdarstellung und
Fig. 5 eine perspektivische Darstellung einer dritten erfindungsgemäßen Ausführungsform der Gehäuseabdichtung, veranschaulicht am Beispiel eines Gehäusedeckels.

### Ausführungsformen der Erfindung

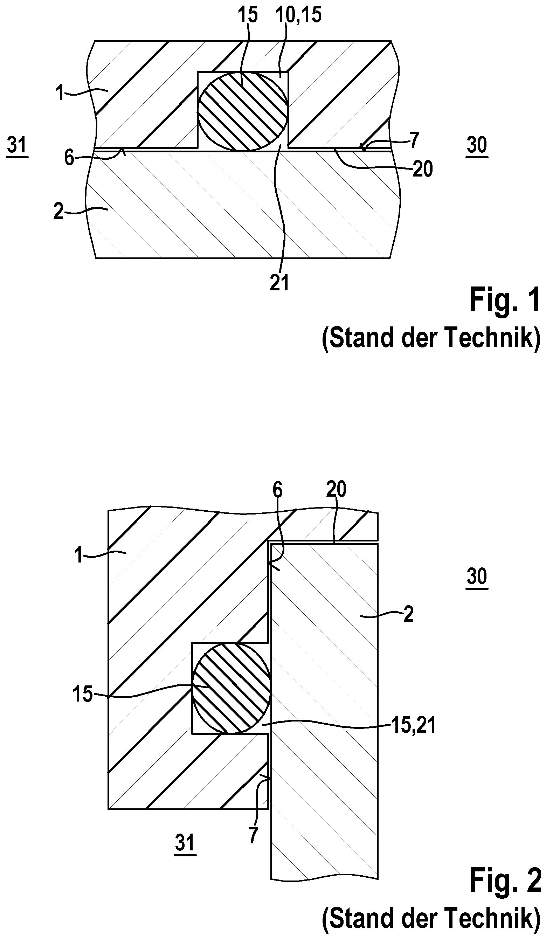

Korrosionen an Dichtungsanordnungen werden im Bereich der vorgesehenen Dichtung durch deren Platzierung in meist konstruktiv tiefen und engen Spalten gefördert. Derartige Standard-Gehäuseabdichtungen bzw. Standard-Konstruktionen sind bekannt und in Fig. 1 und Fig. 2 näher gezeigt. Dabei ist in einem in Fig. 1 oben gezeigten Gehäuseteil 1 in einer Nut 10 eine umlaufende Dichtung 15 in Form eines axial verpressten O-Rings untergebracht. Die Nut 10 ist von einem zweiten unteren Gehäuseteil 2 abgedeckt. Zwischen einer ersten Dichtfläche 6 des ersten Gehäuseteils 1 und einer zweiten Dichtfläche 7 des zweiten Gehäuseteils liegt ein Fügespalt 20 vor. Außerdem liegt ein von der Dichtung 15 nicht ausgefüllter Nutraum 21 vor, der ebenfalls einen Spalt bildet. Rechts in den Figuren 1 bis 5 ist die korrosive Umgebung eines Gehäuseäußeren durch einen Pfeil 30 und ein gegenüberliegendes Gehäuseinneres durch das Bezugszeichen 31 gekennzeichnet. In Fig. 2 ist die Anordnung vertikal ausgerichtet mit vertikal verlaufenden Dichtflächen 6, 7, die an einer Seite horizontal abknicken. Der O-Ring 15 ist dann entsprechend radial verpresst. Das zweite Gehäuseteil 2 ist an seiner oberen Seite teilweise vom ersten Gehäuseteil 1 aufgenommen, so dass insgesamt ein abgewinkelter, längerer Spaltverlauf 20 gegenüber dem in Fig. 1 vorliegt. In den Figuren 1 und 2 sind das erste Gehäuseteil 1 aus Kunststoff und das zweite Gehäuseteil 2 aus Metall hergestellt.

In den Ausführungsformen nach Figuren 1 und 2 stellt sich Korrosion im Bereich der Dichtung 15 ein. Ursächlich hierfür sind die Kapillarwirkung der Spalte 20 und des Nutraums 21, welche das korrosive Medium zur Dichtung 15 bzw. zur Dichtstelle führen. Dies führt zu einer verlangsamerten Abtrocknung in den Spalten 20 bzw. im Nutraum 21. Die Behinderung des Luft- bzw. Sauerstoffzutritts in den Spalten 20 bzw. in dem Nutraum 21 fördert die Spaltkorrosion. Bei weitverbreiteten Metallen, wie Aluminium und rostfreiem Stahl, ist der Sauerstoffzutritt weiterhin zur Korrosionsabwehr notwendig, um schützende Passivschichten bilden zu können. Als Folge der Behinderung des Luft- bzw. Sauerstoffzutritts ergibt sich eine weitere Verschärfung der Korrosionsbedingungen durch dann stattfindende Korrosionsreaktionen und einer Ansammlung von Korrosionsprodukten, zum Beispiel einer Chloridanreicherung und einer pH-Wert-Absenkung im Fügespalt 20.

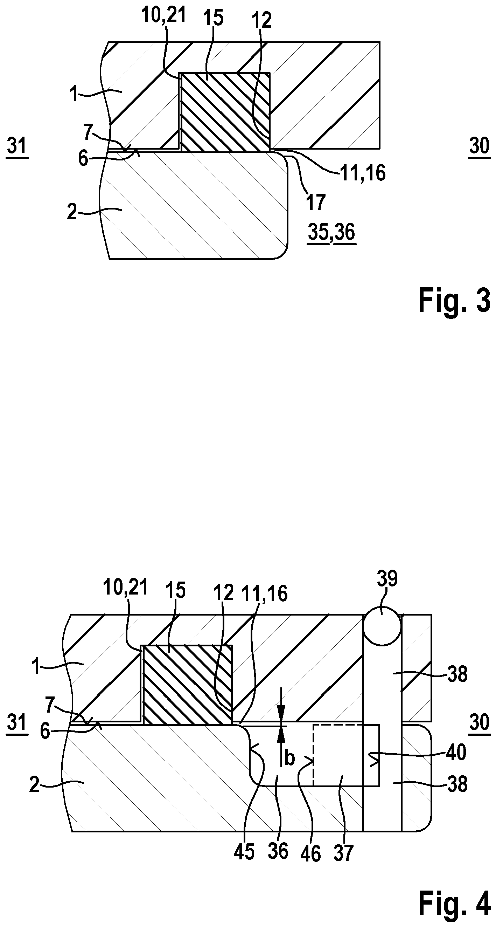

Alle gleichen und gleichwirkenden Bauteile sind in den folgenden Ausführungsbeispielen mit denselben Bezugszeichen wie in den Figuren 1 und 2 versehen. In der Fig. 3 ist eine erste erfindungsgemäße Gehäuseabdichtung zweier Gehäuseteile 1, 2 mittels einer Dichtung 15 gezeigt. Ein oberes, erstes Gehäuseteil 1 liegt mit seiner oberen, ersten Dichtfläche 6 an einer unteren, zweiten Dichtfläche 7 eines unteren, zweiten Gehäuseteils 2 an. Das obere Gehäuseteil 1 weist in seiner oberen Dichtfläche 6 eine eingebrachte Nut 10 auf. In der Nut 10 ist eine Dichtung 15 mit eckigem, insbesondere quadratischem Querschnitt als sogenannte Schlauchabschnittsdichtung eingebracht. Möglich ist auch, eine Dichtung 15 mit einem rechteckförmigen Querschnitt in einer entsprechenden Nut vorzusehen. Möglich ist auch, die Dichtung 15 mit rundem Querschnitt wie in den Figuren 1 und 2 als sogenannte O-Ringdichtung auszubilden. Die Verwendung von Dichtungen mit eckigem Querschnitt hat den Vorteil, dass die Ausbildung eines umlaufenden Spalts, der durch die Auflage eines runden Dichtrings auf ebenen Dichtflächen entsteht, vermindert ist. Die erfindungsgemäße Gehäuseabdichtung ist aber auch bei Verwendung von O-Ringen mit rundem Querschnitt oder für Flüssigkeitsdichtungen vorteilhaft. Die Nut 10 wird von dem unteren Gehäuseteil 2 vollständig überdeckt. Erfindungsgemäß ist nun vorgesehen, dass die Nut 10 eine Öffnung 11 zwischen den Dichtflächen 6, 7 aufweist, welche zur Belüftung der Nut 10 bzw. des Nutraums 21 mit der Dichtung 15 dient. Die Öffnung 11 ist an einem Eckbereich einer dem Gehäuseäußern 30 zuwandten Innenwandung 12 zur unteren Dichtfläche 7 vorgesehen und bildet eine Verbindung zu einem Freibereich 35 im zweiten Gehäuseteil 2 bzw. direkt zur Umgebung. Der Freibereich 35 kann als umlaufende Materialaussparung 36 im zweiten Gehäuseteil 2 ausgeführt sein. Die Öffnung 11 kann radial entlang der Dichtung 15 verlaufen und bildet einen Schlitz 16 in der Nut 10 bzw. im Nutraum 21. Die zweite Dichtfläche 7 überragt die Nut 10 nur minimal und die Öffnung 11 wird durch eine abgebogene bzw. abgerundete bzw. eckige Gestaltung eines Dichtflächendends 17 der zweiten Dichtfläche 7 gebildet.

Wie die Fig. 4, ein zweites erfindungsgemäßes Ausführungsbeispiel, zeigt, kann der Freibereich 35 als Belüftungsnut 37 ausgeführt sein, welche zwischen der Nut 10 mit der Dichtung 15 und einer vorgesehenen Schraubverbindung 39 bzw. an Schraubaugen 38 der beiden Gehäuseteile 1, 2 verläuft. Durch die erfindungsgemäße Öffnung 11 zu einem Freiraum 35 bzw. zu einer Belüftungsnut 37 hin, werden die Abtrocknung und der Luftzutritt insbesondere im kritischen Bereich von vorgesehen Schraubaugen 38 erheblich verbessert, da kein Spalt mehr vorliegt bzw. ein unkritisches Maß vorliegt. Damit wird der Mechanismus der Spaltkorrosion nicht angeregt und eine weitere Verschärfung der Korrosionsbedingungen durch deren Folgeeffekte eines Spalts vermieden. Vorteilhafterweise wird durch die Öffnung 11 ein Kapillareffekt verhindert und auch der Zutritt von Flüssigkeit zum Dichtbereich reduziert, was auch bei Gehäuseteilen 1, 2 aus teilweise oder vollständigem Kunststoff Vorteile mit sich bringt. Die Öffnung 11 ist somit deutlich größer als ein möglicher Fügespalt auszuführen, um so den Kapillareffekt zu verhindern. Als vorteilhafte Öffnungsbreite b für die Öffnung hat sich dabei eine Größenordnung in einem Bereich von 0,5 bis 1 mm als wirksam herausgestellt.

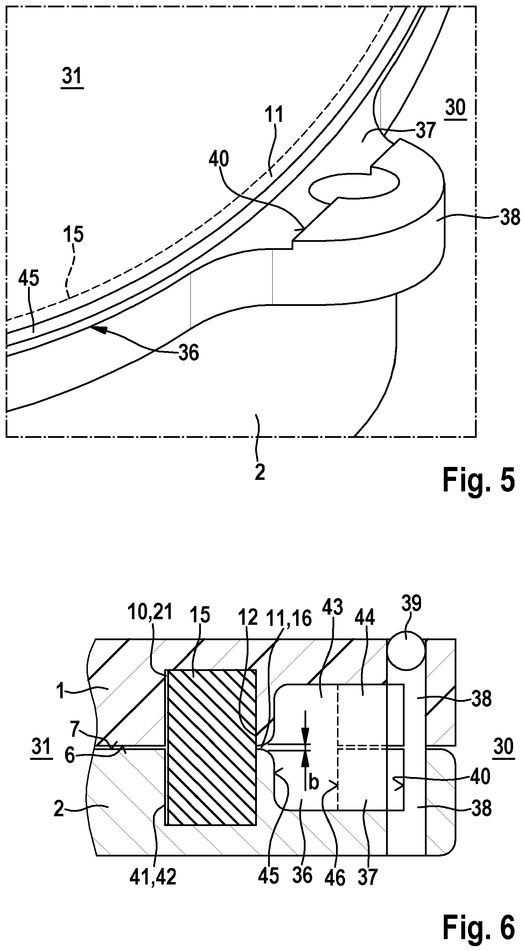

Wie die Fig. 5, ein drittes Ausführungsbeispiel der erfindungsgemäßen Gehäuseabdichtung, zeigt, kann die Gehäuseabdichtung für einen Elektronik-Gehäusedeckel vorgesehen sein. Der Gehäusedeckel stellt dabei das erste Gehäuseteil 1 dar, welches mit dem zweiten, zylindrisch ausgeführten Gehäuseteil 2 zum Beispiel für Elektronikbauteile dicht verbunden ist. Erkennbar ist eine umlaufende Materialaussparung 36 gemäß Fig. 3, die im Bereich vorgesehener Schraubaugen 38 in Form einer Belüftungsnut 37 fortgeführt ist. Gestrichelt angedeutet ist die umlaufende Dichtung 15, welche mit rundem Querschnitt als O-Ringdichtung oder mit eckigem, insbesondere quadratischem Querschnitt als sogenannte Schlauchabschnittsdichtung ausgeführt sein kann.

Durch die erfindungsgemäße Gehäuseabdichtung werden tiefe, enge Spalte vermieden. Dies gewährleistet eine Reduzierung eines Zutritts von korrosivem Medium aus dem Gehäuseäußeren 30 zur Dichtung 15. Außerdem ist eine beschleunigte Abtrocknung und ein verbesserter Sauerstoffzutritt zu den Dichtflächen 6, 7, insbesondere zur Metalloberfläche der zweiten Dichtfläche 7 des zweiten Gehäuseteils 2 möglich. Damit kann das Auftreten von Dichtungsunterwanderung bzw. Spaltkorrosion verhindert werden. In den Figuren 3 und 4 können das erste Gehäuseteil 1 aus Kunststoff und das zweite Gehäuseteil 2 aus Metall hergestellt sein. Möglich ist auch, beide Gehäuseteile 1, 2 komplett aus Metall oder komplett aus Kunststoff herzustellen. Da der Zutritt von Flüssigkeit zum Dichtbereich reduziert ist, ist die Erfindung auch bei Kunststoffoberflächen ohne Korrosion einsetzbar.

Die Erfindung ist für Wasserpumpen, insbesondere für Zusatzwasserpumpen von Kraftfahrzeugen, vorgesehen.

## Patentansprüche

1. Gehäuseabdichtung zweier aneinanderliegender Gehäuseteile, eines ersten Gehäuseteils (1) mit einer ersten Dichtfläche (6) und eines zweiten Gehäuseteils (2) mit einer zweiten Dichtfläche (7), mit einer Dichtung, eingebracht in einer Nut in der ersten Dichtfläche des ersten Gehäuseteils, wobei die Nut von der zweiten Dichtfläche des zweiten Gehäuseteils überdeckt ist, wobei die Nut (10) eine Öffnung (11) zwischen den Dichtflächen (6, 7) aufweist, welche zur Belüftung der Nut (10) mit der eingebrachten Dichtung (15) dient, **dadurch gekennzeichnet, dass** die Öffnung (11) eine Öffnungsbreite (b) in einem Bereich von 0,5 bis 1 mm oder größer aufweist, wobei die Nut (10) von dem zweiten Gehäuseteil vollständig überdeckt ist, wobei die Öffnung (11) eine direkte Verbindung zu einem Freibereich (35) des zweiten Gehäuseteils (2) bzw. der Umgebung bildet, wobei die Öffnung (11) als Schlitz ausgebildet ist und wobei der Schlitz (16) radial entlang der Dichtung (15) verläuft.

2. Gehäuseabdichtung nach Anspruch 1, **dadurch gekennzeichnet, dass** die zweite Dichtfläche (7) des zweiten Gehäuseteils (2) die Nut (10) nur minimal überragt und die Öffnung (11) durch eine abgebogene bzw. abgerundete Gestaltung eines Dichtflächenendes (17) der zweiten Dichtfläche (7) gebildet ist.

3. Gehäuseabdichtung nach Anspruch 1 oder 2, **dadurch gekennzeichnet, dass** die Öffnung (11) zu einer am zweiten Gehäueteil (2) vorgesehenen Aussparung (36) im zweiten Gehäuseteil (2) führt.

4. Gehäuseabdichtung nach Anspruch 3, **dadurch gekennzeichnet, dass** die Aussparung (36) im Bereich von Schraubaugen (38) einer Schraubverbindung (39) in Form einer Belüftungsnut (37) gestaltet ist.

5. Gehäuseabdichtung nach einem der vorherigen Ansprüche 1 bis 4, **dadurch gekennzeichnet, dass** das die Öffnung (11) als Spalt (16) ausgebildet ist.

6. Gehäuseabdichtung nach einem der vorherigen Ansprüche 1 bis 5, **dadurch gekennzeichnet, dass** die Dichtung (15) als O-Ringdichtung mit rundem Querschnitt ausgeführt ist.

7. Gehäuseabdichtung nach einem der vorherigen Ansprüche 1 bis 6, **dadurch gekennzeichnet, dass** die Dichtung (15) einen eckigen, insbesondere quadratischen Querschnitt aufweist.

8. Gehäuseabdichtung nach einem der vorherigen Ansprüche 1 bis 7, **dadurch gekennzeichnet, dass** zumindest ein Gehäuseteil (1; 2) zumindest teilweise aus Metall besteht.

9. Gehäuseabdichtung nach einem der vorherigen Ansprüche 1 bis 8, **dadurch gekennzeichnet, dass** ein Gehäuseteil (1; 2) als Deckel ausgebildet ist.

## Claims

1. Housing seal of two housing parts lying against each other, of a first housing part (1) with a first sealing surface (6) and of a second housing part (2) with a second sealing surface (7), with a seal introduced in a groove in the first sealing surface of the first housing part, wherein the groove is covered by the second sealing surface of the second housing part, wherein the groove (10) has an opening (11) between the sealing surfaces (6, 7), said opening serving for ventilation of the grooves (10) with the introduced seal (15), **characterized in that** the opening (11) has an opening width (b) within a range of 0.5 to 1 mm or greater, wherein the groove (10) is completely covered by the second housing part, wherein the opening (11) forms a direct connection to a free region (35) of the second housing part (2) or of the surroundings, wherein the opening (11) is designed as a slot, and wherein the slot (16) runs radially along the seal (15).

2. Housing seal according to Claim 1, **characterized in that** the second sealing surface (7) of the second housing part (2) protrudes only minimally above the groove (10), and the opening (11) is formed by a bent or rounded configuration of a sealing surface end (17) of the second sealing surface (7).

3. Housing seal according to Claim 1 or 2, **characterized in that** the opening (11) leads to a recess (36), which is provided on the second housing part (2), in the second housing part (2).

4. Housing seal according to Claim 3, **characterized in that** the recess (36) is configured in the form of a ventilation groove (37) in the region of screw eyelets (38) of a screw connection (39).

5. Housing seal according to one of the preceding Claims 1 to 4, **characterized in that** the opening (11) is designed as a gap (16).

6. Housing seal according to one of the preceding Claims 1 to 5, **characterized in that** the seal (15) is embodied as an O-ring seal with a round cross section.

7. Housing seal according to one of the preceding Claims 1 to 6, **characterized in that** the seal (15) has a polygonal, in particular square cross section.

8. Housing seal according to one of the preceding Claims 1 to 7, **characterized in that** at least one housing part (1; 2) is at least partially composed of metal.

9. Housing seal according to one of the preceding claims 1 to 8, **characterized in that** one housing part (1; 2) is designed as a cover.

## Revendications

1. Dispositif d'étanchéité de boîtier entre deux parties de boîtier adjacentes, d'une première partie de boîtier (1) avec une première face d'étanchéité (6) et d'une deuxième partie de boîtier (2) avec une deuxième face d'étanchéité (7), avec un joint d'étanchéité, inséré dans une rainure dans la première face d'étanchéité de la première partie de boîtier, dans lequel la rainure est recouverte par la deuxième face d'étanchéité de la deuxième partie de boîtier, dans lequel la rainure (10) présente une ouverture (11) entre les faces d'étanchéité (6, 7), qui permet de ventiler la rainure (10) avec le joint d'étanchéité inséré (15), **caractérisé en ce que** l'ouverture (11) présente une largeur d'ouverture (b) dans une plage de 0,5 à 1 mm ou plus, dans lequel la rainure (10) est entièrement recouverte par la deuxième partie de boîtier, dans lequel l'ouverture (11) forme une communication directe vers une région libre (35) de la deuxième partie de boîtier (2) ou vers l'atmosphère, dans lequel l'ouverture (11) est réalisée en forme de fente et dans lequel la fente (16) s'étend radialement le long du joint d'étanchéité (15).

2. Dispositif d'étanchéité de boîtier selon la revendication 1, **caractérisé en ce que** la deuxième face d'étanchéité (7) de la deuxième partie de boîtier (2) ne dépasse la rainure (10) que de façon minimale et l'ouverture (11) est formée par une configuration incurvée ou arrondie d'une extrémité de face d'étanchéité (17) de la deuxième face d'étanchéité (7).

3. Dispositif d'étanchéité de boîtier selon la revendication 1 ou 2, **caractérisé en ce que** l'ouverture (11) conduit à un évidement (36) dans la deuxième partie de boîtier (2) prévu sur la deuxième partie de boîtier (2)

4. Dispositif d'étanchéité selon la revendication 3, **caractérisé en ce que** l'évidement (36) est configuré à la forme d'une rainure de ventilation (37) dans la région d'ailettes de vissage (38) d'un assemblage vissé (39).

5. Dispositif d'étanchéité de boîtier selon l'une quelconque des revendications précédentes 1 à 4, **caractérisé en ce que** l'ouverture (11) est réalisée sous forme de fente (16).

6. Dispositif d'étanchéité de boîtier selon l'une quelconque des revendications précédentes 1 à 5, **caractérisé en ce que** le joint d'étanchéité (15) est formé par un joint torique de section transversale ronde.

7. Dispositif d'étanchéité de boîtier selon l'une quelconque des revendications précédentes 1 à 6, **caractérisé en ce que** le joint d'étanchéité (15) présente une section transversale polygonale, en particulier carrée.

8. Dispositif d'étanchéité de boîtier selon l'une quelconque des revendications précédentes 1 à 7, **caractérisé en ce qu'**au moins une partie de boîtier (1; 2) se compose au moins partiellement de métal.

9. Dispositif d'étanchéité de boîtier selon l'une quelconque des revendications précédentes 1 à 8, **caractérisé en ce qu'**une partie de boîtier (1; 2) est réalisée en forme de couvercle.
